# EUROPEAN PATENT APPLICATION

(11) **EP 4 765 310 A1**
(43) Date of publication of application: **24.06.2026**
(21) Application number: 25222258.3
(22) Date of filing: 10.12.2025
(51) Int. Cl.: H01M 10/42

(54) **HIPOT TEST STATION FOR ELECTROCHEMICAL CELL ASSEMBLIES AND METHOD FOR PERFORMING HIPOT TESTS ON ELECTROCHEMICAL CELL ASSEMBLIES**

(30) Priority: 20.12.2024 IT 202400029502
(71) Applicant: G.D S.p.A., 40133 Bologna (BO) (IT)
(72) Inventor: FAZZIOLI, Fabrizio, I-40133 Bologna (BO) (IT)
(74) Representative: Porta & Consulenti Associati S.p.A.

(57) **Abstract**

A Hipot test station (10) for electrochemical cell assemblies comprises a press (11) comprising a first plate (14) and a second plate (15) switchable between a test condition in which the first plate (14) is moved towards the second plate (15) to exert a compressive force on an electrochemical cell assembly (100) and an idle condition in which the first plate (14) is moved away from the second plate (15); a contacting assembly (13) switchable between a contacting condition in which it is configured to electrically contact an electrochemical cell assembly (100) and an idle condition in which it does not electrically contact said electrochemical cell assembly (100); a movement system (12) configured to insert and to remove an electrochemical cell assembly (100) between the first plate (14) and the second plate (15); wherein the first plate (14) is can be moved towards and away from the second plate (15) along a working direction contained in a horizontal plane.

## Description

The present invention relates to a Hipot test station for electrochemical cell assemblies and a method for performing Hipot tests on electrochemical cell assemblies.

The present invention finds preferred, though not exclusive, application in the field of manufacturing electric accumulators involving electrodes stacked on top of each other with a separating layer of dielectric material in between, generally referred to in the technical jargon of the industry as a dielectric "separator".

Electrochemical cell assemblies can be produced in electrode and dielectric separator stacks that are electrically and physically joined together, usually in pairs, and then placed in prismatic containers or in a bag.

The joining of electrode and dielectric separator stacks usually involves mechanically and electrically coupling the same type of poles (e.g. negative poles or positive poles) of two or more stacks together, e.g. by welding, using electrical connectors to define a positive and a negative electrical collector. The electrical poles of each stack are usually placed on opposite sides of the stacks, where the ends of the electrodes are placed. The electrical collectors used to join two or more stacks are therefore arranged at opposite side walls between which side walls extend which are usually flat and continuous. The electrical collectors are also electrically and mechanically connected to metal pins that will implement the electrical poles of the battery. These metal pins, appropriately electrically insulated, are usually connected to a metal or plastic plate that is placed above the stacks joined together.

A so-called Hipot (high potential) test can be performed on the electrochemical cell assemblies to determine the integrity of the electrochemical cells and in particular the dielectric separator. During a Hipot test, controlled voltages are applied to the electrochemical cells for predetermined times and a leakage current is measured. The applied voltages are generally higher than the nominal voltage of the electrochemical cell to test its ability to withstand surges or voltage spikes that may occur under real operating conditions.

In some Hipot test applications, electrochemical cell assemblies are subjected to a compression action at the side walls that do not have electrical poles to further test their ability to withstand surges or voltage spikes.

Document EP 4287345 A1 discloses a pressure triggering device, and in particular a pressure triggering device with a short-circuit control section for a battery cell, wherein the short-circuit control process, the pressure triggering process and the charge/discharge process are performed sequentially and in succession for a plurality of battery cells within a single pressure triggering device, and therefore there is no need to build separate short-circuit control equipment, thereby reducing the maintenance, effort and cost required to perform the short-circuit control process, the pressure activation process and the charge and discharge process for the battery cell.

KR 102677992 B1 discloses a polymer cell pressing device having a structure capable of easily and smoothly measuring a voltage in which battery cells arranged between a pair of pressing dividers arranged on a base frame and a plurality of sliding dividers are pressed by a drive unit and a conduction induction unit is electrically connected to an electrode terminal of each of the battery cells.

In the Applicant's experience, the operations required to place an electrochemical cell assembly in a press of a Hipot test station have certain limitations necessary to avoid damage to the electrochemical cell assembly.

In particular, the Applicant has verified that the walls of the electrochemical cell assembly affected by the electrical connectors, which are used to join for example two stacks, cannot be directly contacted by gripping devices as this would risk damaging those electrical connectors or compromising the electrical continuity with the electrodes of the stacks.

The Applicant has also verified that the compressive action of the press in a Hipot test station should be distributed as evenly as possible on the usually flat and continuous side walls (which run perpendicular to the walls with the electrical connectors) of the electrochemical cell assembly, so that a substantially uniform pressure is transmitted to all internal layers of the electrochemical cell assembly.

The Applicant has also verified that any sliding between the usually flat and continuous side walls of the electrochemical cell assembly and the press plates should be avoided in order to prevent possible damage to the surfaces of the electrochemical cell assembly.

In this context, the Applicant's objective was to set up a Hipot test station that would allow efficient introduction of the electrochemical cell assemblies into the press and that would take into account the above-mentioned limitations.

The Applicant found that by arranging the press plates vertically, it would be possible to insert the electrochemical cell assembly from above into the press while also having the top wall and bottom wall of the electrochemical cell assembly (neither being affected by the electrical connectors) available for grasping the electrochemical cell assembly during its movement in and out of the press. In this way, the electrochemical cell assembly would not be subjected to creeping against the press plates, would not be contacted at the electrical connectors, and it would be possible to shape the press plates in such a way that as even a pressure as possible could be applied to the two side walls of the electrochemical cell assembly.

The present invention therefore concerns, in a first aspect thereof, a Hipot test station for electrochemical cell assemblies.

Preferably, the station comprises a press.

Preferably, the press comprises a first plate and a second plate that can be switched between a test condition in which the first plate is brought close to the second plate to exert a compressive force on an electrochemical cell assembly and an idle condition in which the first plate is moved away from the second plate.

Preferably, the station comprises a contacting assembly switchable between a contacting condition in which it is configured to electrically contact an electrochemical cell assembly and an idle condition in which it does not electrically contact said electrochemical cell assembly.

Preferably, the station comprises a movement system configured to insert and remove an electrochemical cell assembly between the first plate and the second plate.

Preferably, the movement system is switchable between a grasping condition and a release condition.

Preferably, in said grasping condition, said movement system is configured to hold an electrochemical cell assembly at a wall not contacted by said press.

Preferably, the first plate can be moved towards and away from the second plate along a working direction contained in a horizontal plane.

Preferably, said movement system is switched to the release condition when said first plate is brought close to the second plate.

In this way, the electrochemical cell assembly is placed inside the press without the need to rest the base of the electrochemical cell assembly on any support.

By switching the movement system to the release condition when the first plate is brought close to the second plate, the movement system releases the electrochemical cell assembly when the press is exerting compression on the electrochemical cell assembly and thus holding the electrochemical cell assembly in place. The compression force exerted by the first plate and the second plate of the cell prevents the electrochemical cell assembly from moving vertically with respect to the press.

The present invention relates, in a second aspect thereof, to a method for performing a Hipot test on an electrochemical cell assembly.

Preferably, it is provided to set up a press with a first plate and a second plate placed in an approaching relationship along a working direction contained in a horizontal plane.

Preferably, it is provided to move an electrochemical cell assembly along a vertical direction to insert the electrochemical cell assembly between the first plate and the second plate.

Preferably, it is provided to move the first plate towards the second plate along the working direction and apply a compressive force to the electrochemical cell assembly.

Preferably, inserting the electrochemical cell assembly between the first plate and the second plate comprises placing the electrochemical cell assembly between the first plate and the second plate, then moving the first plate towards the second plate until a compressive force is applied to opposite side walls of the electrochemical cell assembly and then releasing the electrochemical cell assembly.

Preferably, controlled voltages are to be delivered to the electrochemical cell assembly.

Preferably, it is provided to move the electrochemical cell assembly along a substantially vertical direction to remove the electrochemical cell assembly from the press.

The term "electrochemical cell assembly" is understood in the context of this description and the following claims to mean an assembly comprising two or more stacks joined together, wherein each stack is made from a plurality of electrodes (anode and cathode) alternating with each other and separated by a dielectric separator. The electrodes are made from pieces of metal material in foil form and the dielectric separator can be a continuous strip arranged in a serpentine pattern between the electrodes or a plurality of pieces in foil form.

The term "horizontal" is used in the context of the present description and subsequent claims in its common meaning, i.e. relating to a plane or direction contained in a plane that is perpendicular to the vector of gravity acceleration. A horizontal plane is perpendicular to the direction according to which the plumb line is placed.

The term "vertical" is used in the context of the present description and subsequent claims in its common meaning, i.e. relating to a plane or direction contained in a plane that is parallel to the vector of gravity acceleration. A vertical plane contains the direction according to which the plumb line is placed.

The present invention may have at least one of the preferred features described below. Such features may thus be present individually or in combination with each other, unless expressly stated otherwise, in any one of the aspects of the present invention.

Preferably, the electrochemical cell assembly is substantially prismatic in shape.

Preferably, the electrochemical cell assembly comprises a base, a top and four sides arranged substantially orthogonal to one other and orthogonal to the base and top.

Preferably, two sides that are parallel to each other comprise respective flat and substantially continuous side walls.

Preferably, two further parallel sides each comprise an electrical connector made of an electrically conductive material.

Preferably, the top comprises a lid comprising two electrically conductive poles made of electrically conductive material.

Preferably, the lid is connected to an electrically non-conductive material holder facing the inside of the electrochemical cell assembly.

Preferably, the support is inserted between the two side walls of the electrochemical cell assembly.

Preferably, each electrical pole is mechanically and electrically connected to a respective electrical connector.

Preferably, the electrochemical cell assembly comprises a wrapping tape wrapped around at least the base and side walls.

Preferably, the wrapping tape covers both side walls up to the lid.

Preferably, the first plate can only be moved towards and away from the second plate along a working direction contained in a horizontal plane.

Preferably, the first and second plates of the press comprise respective contact surfaces configured to contact the side walls of the electrochemical cell assembly, said contact surfaces being flat, continuous surfaces.

The contact surfaces of the first and second presses are preferably facing each other.

The contact surfaces of the first and second presses are preferably parallel to each other.

The contact surfaces of the first and second presses are contained in a vertical plane when in the test condition.

The contact surfaces of the first and second presses are contained in a vertical plane when in the idle condition.

Preferably, applying a compressive force to the electrochemical cell assembly comprises contacting the side walls of the electrochemical cell assembly without contacting the lid of the electrochemical cell assembly.

The Applicant noted that the lid of the electrochemical cell assembly could be damaged if subjected to a compressive action and could damage the electrochemical cell assembly.

Preferably, the contact surfaces of the first and second presses do not contact the lid of the electrochemical cell assembly.

The press can be a hydraulic or pneumatic press that drives the first plate and the second plate towards and away from each other to put them in the test condition and the idle condition.

Preferably, in said grasping condition said movement system is configured to hold the electrochemical cell assembly at the top of the electrochemical cell assembly.

Preferably, in said grasping condition said movement system is configured to hold the electrochemical cell assembly at the lid of the electrochemical cell assembly.

Preferably, moving the electrochemical cell assembly comprises retaining the electrochemical cell assembly along a wall of the electrochemical cell assembly other than walls of the electrochemical cell assembly on which said press acts.

Preferably, moving the electrochemical cell assembly comprises holding the electrochemical cell assembly along the top of the electrochemical cell assembly.

Preferably, moving the electrochemical cell assembly comprises holding the electrochemical cell assembly along the lid of the electrochemical cell assembly.

The Applicant has verified that by holding the electrochemical cell assembly at the top, the electrochemical cell assembly is arranged substantially vertically, i.e. with the side walls arranged vertically.

Preferably, placing the electrochemical cell assembly between the first plate and the second plate comprises moving the electrochemical cell assembly in a vertical direction to bring it into the press.

Preferably, said movement system is configured to translate the electrochemical cell assembly between the first press plate and the second press plate in a vertical direction.

In this way, the electrochemical cell assembly remains inside the press, positioned vertically, preventing the electrochemical cell assembly from moving vertically with respect to the press.

Preferably, after applying a compressive force to the side walls of the electrochemical cell assembly, it is provided to release the electrochemical cell assembly.

When the electrochemical cell assembly is placed between the first plate and the second plate, and while the press exerts a compressive action on the side walls of the electrochemical cell assembly, it is preferable to apply controlled voltages to the electrochemical cell assembly.

Preferably, delivering controlled voltages to the electrochemical cell assembly is implemented subsequently to release the electrochemical cell assembly.

Preferably, delivering controlled voltages to the electrochemical cell assembly is preferably carried out with the contacting assembly in the contacting condition.

Preferably, delivering controlled voltages to the electrochemical cell assembly is preceded by contacting the electrochemical cell assembly with the contacting assembly.

Preferably, the contacting assembly is switched to the contacting condition after releasing the electrochemical cell assembly.

Preferably, the contacting assembly is switched to the contacting condition when the movement system is switched to the release condition.

In fact, the contacting assembly is preferably configured, in the contacting condition, to contact the electrical poles placed on the lid of the electrochemical cell assembly.

By releasing the lid of the electrochemical cell assembly from the movement system, it is then possible to switch the contacting assembly to the contacting condition more easily.

Preferably, delivering controlled voltages to the electrochemical cell assembly comprises delivering voltages above the rated voltage of the electrochemical cell assembly.

Preferably, removing the electrochemical cell assembly from the press is implemented subsequently to delivering controlled voltages to the electrochemical cell assembly.

Preferably, removing the electrochemical cell assembly from the press comprises holding the electrochemical cell assembly while it is compressed between the first plate and the second plate.

The movement system is configured to be switched into the grasping condition when said first plate is still close to the second plate.

Preferably, the movement system is configured to be switched to the grasping condition when the contacting assembly is switched to the idle condition.

Preferably, holding the electrochemical cell assembly while it is compressed between the first plate and the second plate is implemented subsequently to switching the contacting assembly to the idle condition.

After holding the electrochemical cell assembly while it is compressed between the first plate and the second plate, it is preferable to move the first plate away from the second plate.

The movement system switched into the grasping condition prevents the electrochemical cell assembly from moving vertically and falling when the first plate is moved away from the second plate.

Preferably, subsequently to holding the electrochemical cell assembly while it is compressed between the first plate and the second plate, it is provided to move the electrochemical cell assembly while it is being held.

Preferably, to hold the electrochemical cell assembly said movement system comprises a suction device.

Preferably, the suction device is configured to operate on the lid of the electrochemical cell assembly.

Preferably, the contact surfaces of the first plate and the second plate do not act in an area of the electrochemical cell assembly where the lid and lid support are present.

Electrodes of the electrochemical cell assembly are not usually placed in this area. In this area, the lid and support close the electrochemical cell assembly at the top. In this area, an end portion of the wrapping tape is placed on the side walls of the electrochemical cell assembly.

The Applicant has verified that the application of the compressive force of the first plate and the second plate in this area could cause damage to the electrochemical cell assembly due to possible deformation of the lid or lid support.

However, the Applicant found that by applying a lower compressive force in this area than that applied by the first plate and the second plate, it would be possible to improve the adhesion of the wrapping tape.

Preferably, said press comprises a first slider placed at one end of the first plate.

Preferably, a first slider is provided, configured to apply a compressive force to a side wall of the electrochemical cell assembly in proximity to the lid.

The first slider allows a compressive force to be applied to the wrapping tape at one end of the tape facing the lid, allowing the wrapping tape to properly adhere to the side wall of the electrochemical cell assembly.

Preferably, a compressive force, measured per unit area, exerted by said first slider is less than the compressive force, measured per unit area, exerted by said first plate.

Preferably, a maximum compressive force exerted by the first slider, measured per unit area, is comprised between 0.05 and 0.8, more preferably between 0.1 and 0.7, more preferably between 0.2 and 0.5 times the compressive force, measured per unit area, exerted by the contact surface of the first press plate.

The first slider has the function of applying a compressive force to the area of the electrochemical cell assembly placed at the lid support.

Preferably, the first slider is configured to apply an increasing compression force up to a maximum compression force at the lid support.

Preferably, the first slider is switchable between a first end position in which it is close to the second plate and a second end condition in which it is distanced from the second plate.

In the second end position, the first slider exerts a maximum compression force in the area of the electrochemical cell assembly placed at the lid support.

Preferably, the first slider comprises a contact surface configured to contact a portion of the electrochemical cell assembly.

Preferably, this portion of the electrochemical cell assembly coincides with the area of the electrochemical cell assembly placed at the lid support.

Preferably, when said first slider is in the first end position, said contact surface of the first slider is closer to the second plate than the contact surface of the first plate.

Thus, as the first plate moves towards the side wall of the electrochemical cell assembly, the first slider begins to contact the area of the electrochemical cell assembly placed at the lid support and exert a slight compressive force that becomes maximum when the first plate contacts the side wall of the electrochemical cell assembly.

Preferably, it is provided to apply a maximum compressive force with said first slider when the first plate is in the test condition.

Preferably, it is provided to switch the first slider to the second condition before delivering controlled voltages to the electrochemical cell assembly.

Preferably, said press further comprises a second slider at one end of the second plate.

Preferably, a second slider is provided, configured to apply a compressive force to a side wall of the electrochemical cell assembly in proximity to the lid.

The first slider allows a compressive force to be applied to the wrapping tape at one end of the tape facing the lid, allowing the wrapping tape to properly adhere to the side wall of the electrochemical cell assembly.

Preferably, a compressive force, measured per unit area, exerted by said second slider is less than the compressive force, measured per unit area, exerted by said second plate.

Preferably, a maximum compressive force, measured per unit area, exerted by the second slider is comprised between 0.05 and 0.8, more preferably comprised between 0.1 and 0.7, more preferably between 0.2 and 0.5 times the compressive force, measured per unit area, exerted by the contact surface of the second press plate.

The second slider has the function of applying a compressive force to the area of the electrochemical cell assembly placed at the lid support.

Preferably, the second slider is configured to apply an increasing compression force up to a maximum compression force at the lid support.

Preferably, the second slider is switchable between a first end position in which it is close to the first plate and a second end condition in which it is distanced from the first plate.

In the second end position, the second slider exerts a maximum compression force in the area of the electrochemical cell assembly placed at the lid support.

Preferably, the second slider comprises a contact surface configured to contact a portion of the electrochemical cell assembly.

Preferably, this portion of the electrochemical cell assembly coincides with the area of the electrochemical cell assembly placed at the lid support.

Preferably, when said second slider is in the first end position, said contact surface of the second slider is closer to the first plate than the contact surface of the second plate.

Thus, as the second plate moves towards the side wall of the electrochemical cell assembly, the second slider begins to contact the area of the electrochemical cell assembly placed at the lid support and exert a slight compressive force that becomes maximum when the second plate contacts the side wall of the electrochemical cell assembly.

Preferably, a maximum compressive force should be applied with said second slider when the second plate is in the test condition.

Preferably, it is provided to switch the second slider to the second condition before delivering controlled voltages to the electrochemical cell assembly.

Further features and advantages of the present invention will be better apparent from the following detailed description of a preferred embodiment thereof, with reference to the appended drawings and provided by way of indicative and nonlimiting example, wherein:
- Figure 1 is a schematic view of a Hipot test station for electrochemical cell assemblies in accordance with the present invention;
- Figures 2 to 5 are schematic views of the station in Figure 1 under different operating conditions; and
- Figure 6 is a schematic view of an electrochemical cell assembly.

The representations in the appended figures do not necessarily have to be understood in scale and do not necessarily respect the proportions between the various parts.

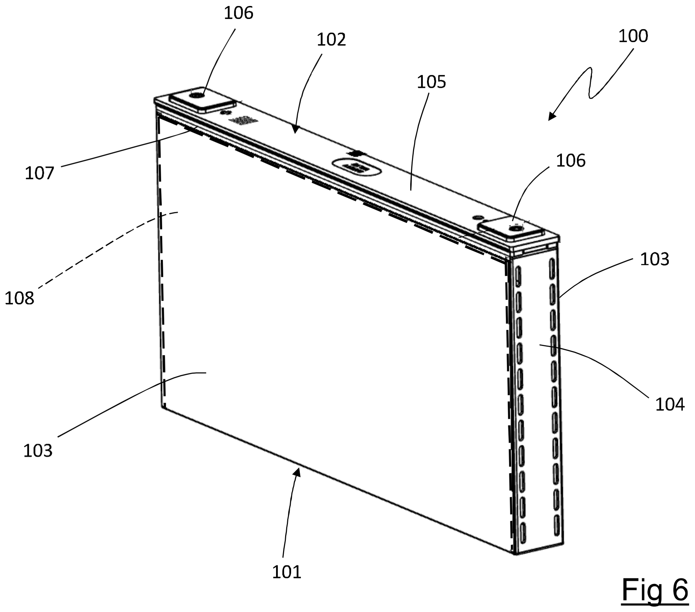

Figure 6 shows with the number 100 an electrochemical cell assembly that can be Hipot tested in a Hipot test station in accordance with the present invention.

The electrochemical cell assembly 100 shown in Figure 6 consists of two stacks joined together. The electrochemical cell assembly 100 comprises a base 101, a top 102 and four sides arranged substantially orthogonal to one other and orthogonal to the base 101 and the top 102. The four sides comprise two major sides that define two side walls 103 parallel to each other. The two side walls 103 extend from the base 101 to the top 102. Between the two side walls 103 are electrical connectors 104 made of conductive material each connected to respective electrodes (not shown) placed in the electrochemical cell assembly.

At the top 102 is a substantially flat lid 105 with two electrical poles 106 each connected to a respective electrical connector 104. The lid 105 comprises a support 107 facing the base 101. The support 107 is placed between the two side walls 103. The side walls 103 extend to contact the lid 105. The electrodes of the electrochemical cell assembly are placed immediately below, and slightly distanced from, the support 107. The electrodes extend substantially to the base 101.

The two side walls 103 are flat and continuous. A wrapping strip 108 (shown with a broken line in Figure 6) wraps the two side walls 103 and the base 101 externally. The tape 108 reaches the lid 105 without contacting it. The electrical connectors 104 are preferably covered with inserts (not shown) made of non-conductive material. The electrochemical cell assembly 100 is configured to fit into a prismatic container or bag to form a battery.

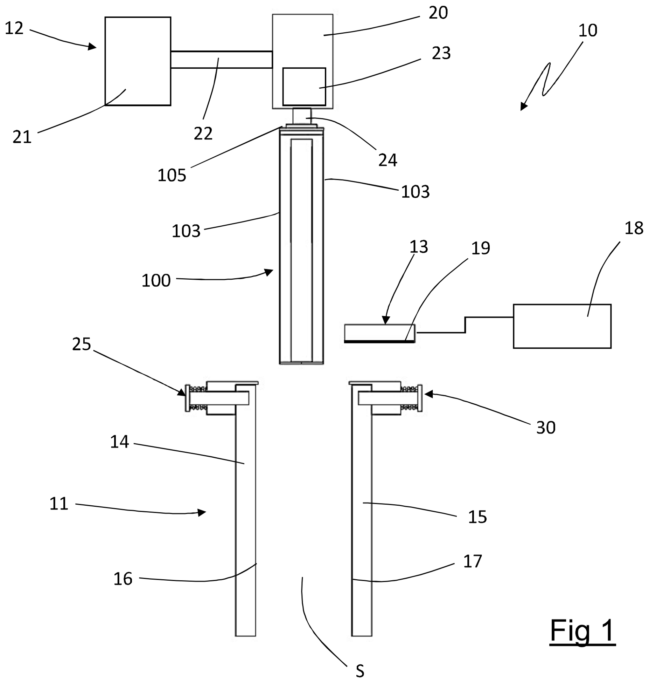

In Figure 1, a Hipot test station in accordance with the present invention is indicated as a whole with the number 10.

The station 10 comprises a press 11, a movement system 12 for an electrochemical cell assembly 100 and a contacting unit 13.

The press 11 comprises a first plate 14 and a second plate 15 placed between them facing each other in such a way as to define an empty space S between them. The first plate 14 comprises a flat and continuous contact surface 16. The contact surface 16 is arranged along a vertical plane. The second plate 15 also comprises a flat and continuous contact surface 17 . The contact surface 17 is arranged along a vertical plane and is parallel to the contact surface 16 of the first plate 14. The contact surfaces 16, 17 are directly facing each other.

The first plate 14 and the second plate 15 are both movable towards and away from each other along a horizontal direction. The first plate 14 and the second plate 15 are movable between an idle condition and a test condition. In the idle condition, the first plate 14 and the second plate 15 are further apart than in the test condition. A movement device e.g. hydraulic (not shown) provides to move the first plate 14 and the second plate 15. The contact surfaces 16, 17 of the first plate 14 and the second plate 15 are larger than the side walls 103 of the electrochemical cell assembly.

The contacting assembly 13 is placed in electrical connection with a power device 18 configured to deliver voltages controlled in time and intensity. The power device 18 is configured to deliver higher voltages than the rated voltage of the electrochemical cell assembly 100 for a period of time comprised between 10 seconds and 10 minutes. The contacting assembly 13 comprises a pair of contacting plates 19 each configured to mechanically and electrically contact a respective electrical pole 106 of the electrochemical cell assembly 100. The contacting assembly 13 is made movable to be switched between a contacting condition in which the contacting plates 19 contact the electrical poles 106 of the electrochemical cell assembly 100 and an idle condition in which the contacting plates 19 contact the electrical poles 106 of the electrochemical cell assembly 100. The contacting assembly 13 is electrically connected to the power device 18 at least when the contacting assembly 13 is in the contacting condition.

The movement system 12 comprises a movement head 20 kinematically connected to an actuator 21, for example an electric motor, through, for example, an articulated arm 22 (depicted in Figure 1). The movement head 20 comprises a suction device 23 configured to generate a vacuum. The suction device 23 comprises a plurality of suction heads 24 placed at a lower end of the movement head 20, as schematically illustrated in Figure 1. The movement system 12 is configured to grasp an electrochemical cell assembly 100 at the lid 105. In particular, the suction heads 24 are configured to contact the lid 105 of the electrochemical cell assembly 100 and to hold (when the suction device 23 is activated) the electrochemical cell assembly 100 against the force of gravity. The movement system 12 is configured to move the electrochemical cell assembly 100 through space when grasped by the suction heads 24. In particular, the movement system 12 is configured to move the electrochemical cell assembly 100 at least in a vertical direction when grasped by the suction heads 24.

The press 11 comprises a first slider 25 placed at an upper end of the first plate 14. The first slider 25 is mechanically connected to the first plate 14 in order to move in a horizontal direction with respect to the first plate 14. The first slider 25 moves with respect to the first plate 14 against the elastic force exerted by a spring 26. Structurally, the first slider 25 comprises a pin 27 having a horizontal axis driven into the first plate 14. The spring 26 is inserted on the pin and rests on one side on the first plate 14 (opposite the contact surface 16) and, on the opposite side, on a head of the pin 27. The pin passes through a body 28 of the first slider 25 in such a way that the body 28 of the first slider 25 slides horizontally guided by the pin 27. The first slider 25 comprises a contact surface 29 arranged parallel to the contact surface 16 of the first plate 14. The contact surface 29 is formed on the body 28 of the first slider 25. The contact surface 29 of the first slider 25 is placed immediately above the contact surface of the first plate 14. The contact surface 29 of the first slider 25 is movable in the horizontal direction with respect to the contact surface 16 of the first plate 14. The first slider 25 is switchable between a first end position in which it is close to the second plate 15 and a second end condition in which it is distanced from the second plate 15. In the first end position, the contact surface 29 of the first slider 25 is not aligned in the vertical direction with the contact surface 16 of the first plate 14. In the first end position, the contact surface 29 of the first slider 25 is closer to the second plate 15 than the contact surface 16 of the first plate 14. At the second end position, the contact surface 29 of the first slider 25 can be substantially aligned in the vertical direction with the contact surface 16 of the first plate 14. The second end position can only be reached against the elastic force exerted by the spring 26. The entire first slider 25 also moves in solidarity with the first plate 14.

The press 11 further comprises a second slider 30 placed at an upper end of the second plate 15. The second slider 30 is mechanically connected to the second plate 15 in order to move in a horizontal direction with respect to the second plate 15. The second slider 30 moves with respect to the second plate 15 against the elastic force exerted by a spring 31. Structurally, the second slider 30 comprises a pin 32 having a horizontal axis driven into the second plate 15. The spring 31 is inserted on the pin 32 and rests on one side on the second plate 15 (on the opposite side with respect to the contact surface 17) and, on an opposite side, on a head of the pin 32. The pin 32 passes through a body 33 of the second slider 30 in such a way that the body 33 of the second slider 30 slides horizontally guided by the pin 32. The second slider 30 comprises a contact surface 34 arranged parallel to the contact surface 17 of the second plate 15. The contact surface 34 is formed on the body 33 of the second slider 30. The contact surface 34 of the second slider 30 is placed immediately above the contact surface 17 of the second plate 15. The contact surface 34 of the second slider 30 is movable in a horizontal direction with respect to the contact surface 17 of the second plate 15. The second slider 30 is switchable between a first end position in which it is closer to the first plate 14 and a second end condition in which it is distanced from the first plate 14. In the first end position, the contact surface 34 of the second slider 30 is not aligned in the vertical direction with the contact surface 17 of the second plate 15. In the first end position, the contact surface 34 of the second slider 30 is closer to the first plate 14 than is the contact surface 17 of the second plate 15. In the second end position, the contact surface 34 of the second slider 30 can be substantially aligned in a vertical direction with the contact surface 17 of the second plate 15. The second end position can only be reached against the elastic force exerted by the spring 31. The entire second slider 30 also moves in solidarity with the second plate 15.

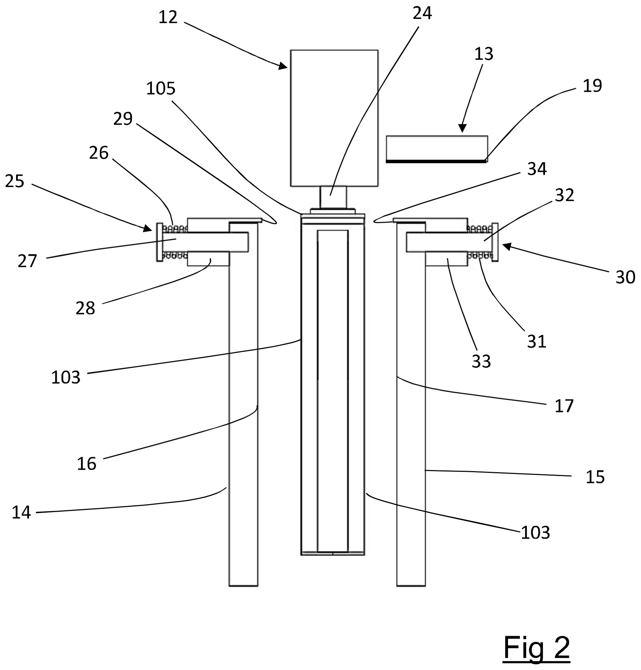

Figures 2 to 5 schematically illustrate a method for performing a Hipot test on the electrochemical cell assembly 100 using a Hipot test station 10 such as the one described above.

This method involves grasping an electrochemical cell assembly 100 and placing it vertically above the press 11.

This is done by placing the movement head 20 of the movement system 12 at the lid 105 of the electrochemical cell assembly 100. The suction heads 24 are placed on the lid 105 and the suction device 23 is activated. The electrochemical cell assembly 100 is then held in a vertical position supported by the movement system 12. The contacting assembly 13 is in the idle condition and the press 11 is in the idle condition. The first slider 25 and the second slider 30 are in their respective first end positions (as shown in Figure 1).

Next, the movement system 12 vertically translates the electrochemical cell assembly 100 in the press 11 between the first plate 14 and the second plate 15. This is done by inserting the electrochemical cell assembly 100 into the empty space S between the first plate 14 and the second plate 15. The first plate 14 and the second plate 15 are in the idle condition. The contacting assembly 13 is in the idle condition. The electrochemical cell assembly 100 is held in a vertical position supported by the movement system 12. The first slider 25 and the second slider 30 are in their respective first end positions (as shown in Figure 2).

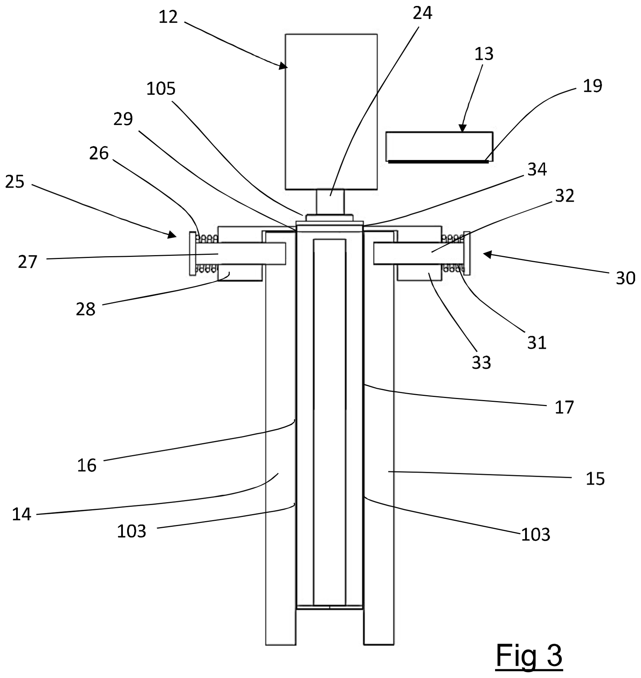

Subsequently or simultaneously, the first plate 14 and the second plate 15 are moved horizontally towards each other. Only when the movement system 12 stops the vertical descent of the electrochemical cell assembly 100 do the first plate 14 and the second plate 15 reach the test condition. In this condition, the first plate 14 and the second plate 15 exert a compressive action on the side walls 103 of the electrochemical cell assembly 100. The movement system 12 places the electrochemical cell assembly 100 in such a position that the lid 105 is placed out of the action of the contact surfaces 16, 17 of the first plate 14 and the second plate 15. The movement system 12 places the electrochemical cell assembly 100 in a position such that the support 107 of the lid 105 is placed out of the action of the contact surfaces 16, 17 of the first plate 14 and the second plate 15. Thus, in the test condition, the contact surfaces 16, 17 of the first plate 14 and the second plate 15 do not contact the lid 105 of the electrochemical cell assembly 100. The contact surfaces 16, 17 of the first plate 14 and the second plate 15 do not contact the side walls 103 at the support 107 of the lid 105, as shown in Figure 3. The movement system 12 places the electrochemical cell assembly 100 in a position such that the contact surfaces 29, 34 of the first slider 25 and the second slider 25 do not contact the lid 105 of the electrochemical cell assembly 100. The movement system 12 places the electrochemical cell assembly 100 in a position such that the contact surfaces 29, 34 of the first slider 25 and the second slider 30 contact the side walls 103 of the electrochemical cell assembly in exact correspondence with the support 107 of the lid 105, as depicted in Figure 3. The contact surfaces 29, 34 of the first slider 25 and the second slider 30 are thus horizontally aligned with the support 107. The first slider 25 and the second slider 30 are in their respective second end positions. The first slider 25 and the second slider 30 then exert a compressive action on the side walls 103 of the electrochemical cell assembly 100 at the support 107 of the lid 105. This compression action is implemented by the springs 26, 31 of the first slider 25 and the second slider 30. This compressive action is less than the compressive action exerted by the first plate 14 and the second plate 15. By way of example, the compressive action per unit area exerted by the first slider 25 and the second slider 30 may be approximately 0.5 times the compressive action per unit area exerted by the first plate 14 and the second plate 14. The contacting assembly 13 is in the idle condition.

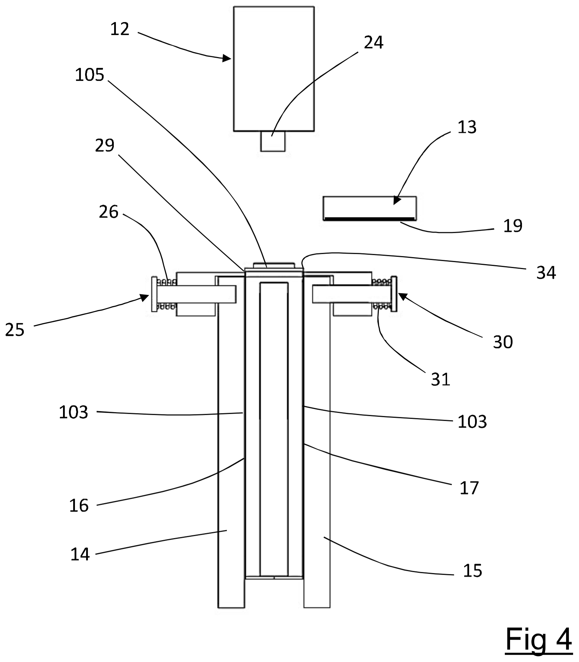

When the first plate 14 and the second plate 15 exert the aforementioned compressive action on the side walls 103 of the electrochemical cell assembly 100, the movement system 12 releases the electrochemical cell assembly 100 and moves away from the press 11, as depicted in Figure 4. The electrochemical cell assembly 100 remains clamped in the press 11 and remains in the position reached without being able to move vertically due to friction between the side walls 103 and the contact surfaces 16, 17 of the first plate 14 and the second plate 15. The first slider 25 and the second slider 30 are in their respective second end positions.

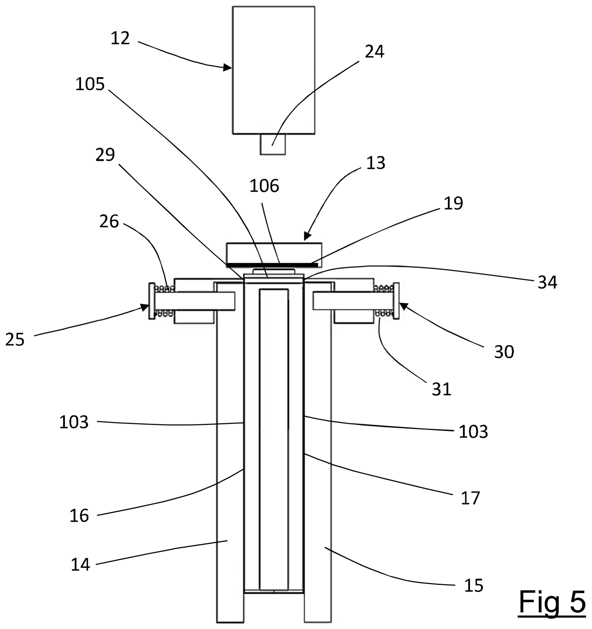

Subsequently or simultaneously, the contacting assembly 13 is placed in the contacting condition, as depicted in Figure 5. The contacting plates 19 contact the electrical poles 106 of the electrochemical cell assembly 100.

The power device 18 is then activated, which delivers controlled voltages to the electrochemical cell assembly 100 via the contacting assembly 13 to test the ability of the electrochemical cell assembly 100 to withstand voltage surges or spikes.

After the controlled supply of voltage has been completed, the contacting assembly is moved into the idle condition.

When the contacting assembly reaches the idle condition, the movement system 12 grasps the electrochemical cell assembly 100.

This is done by placing the movement head 20 of the movement system 12 at the lid 105 of the electrochemical cell assembly 100. The suction heads 24 are placed on the lid 105 and the suction device 23 is activated. The electrochemical cell assembly 100 is then retained. The press 11 is in the test condition. The first slider 25 and the second slider 30 are in their respective second end positions.

Subsequently or simultaneously, the first plate 14 and the second plate 15 are moved horizontally apart. The first plate 14 and the second plate 15 progressively decrease the compressive action on the side walls 103 of the electrochemical cell assembly 100 until they return to the idle condition. In this condition, the first plate 14 and the second plate 15 exert no compressive action on the electrochemical cell assembly. At the same time, the contact surfaces 29, 34 of the first slider 25 and the second slider 30 progressively decrease the compressive action on the side walls 103 of the electrochemical cell assembly 100 until they return to their respective first end positions. In these positions, the contact surfaces 29, 34 of the first slider 25 and the second slider 30 exert no compressive action on the electrochemical cell assembly. During these actions, the movement system 12 continues to retain the electrochemical cell assembly 100.

When the first plate 14 and the second plate 15 reach the idle position, the movement system lifts the electrochemical cell assembly 100 by translating it vertically. This operation results in the electrochemical cell assembly leaving the press 11 and a further Hipot test can be started on a further electrochemical cell assembly 100 by repeating the actions described above.

## Claims

1. Hipot test station (10) for electrochemical cell assemblies comprising:
a press (11) comprising a first plate (14) and a second plate (15) switchable between a test condition in which the first plate (14) is brought close to the second plate (15) to exert a compressive force on an electrochemical cell assembly (100) and an idle condition in which the first plate (14) is moved away from the second plate (15);
a contacting assembly (13) switchable between a contacting condition in which it is configured to electrically contact an electrochemical cell assembly (100) and an idle condition in which it does not electrically contact said electrochemical cell assembly (100);
a movement system (12) configured for inserting and removing an electrochemical cell assembly (100) between the first plate (14) and the second plate (15),switchable between a grasping condition and a release condition, wherein in said grasping condition said movement system (12) is configured to hold an electrochemical cell assembly (100) at a wall not contacted by said press (11), wherein said first plate (14) is movable towards and away from the second plate (15) along a working direction contained in a horizontal plane, wherein said movement system (12) is switchable to the release condition when said first plate (14) is brought close to the second plate (15).

2. Hipot test station (10) according to claim 1, wherein the first plate (14) and the second plate (15) comprise respective contact surfaces (16, 17) configured to contact side walls (103) of an electrochemical cell assembly (100), said contact surfaces (16, 17) being flat, continuous surfaces.

3. Hipot test station (10) according to claim 1, wherein said movement system (12) comprises a suction device (23) configured to grasp and hold an electrochemical cell assembly (100).

4. Hipot test station (10) according to any one of the preceding claims, wherein in said grasping condition said movement system (12) is configured to retain the electrochemical cell assembly (100) at a top (102) of the electrochemical cell assembly (100).

5. Hipot test station (10) according to any one of the preceding claims, wherein in said grasping condition said movement system (12) is configured to retain the electrochemical cell assembly (100) at a lid (105) of the electrochemical cell assembly.

6. Hipot test station (10) according to any one of the preceding claims, wherein said press (11) comprises a first slider (25) placed at an end of said first plate (14) switchable between a first end position in which it is moved towards the second plate (15) and a second end condition in which it is moved away from the second plate (15), said first slider (25) being configured to exert a compressive force on a portion of an electrochemical cell assembly (100) wherein the compressive force, measured per unit area, exerted by said first slider (25) is less than the compressive force, measured per unit area, exerted by said first plate (14).

7. Hipot test station (10) according to claim 6, wherein said press (11) comprises a second slider (30) placed at an end of the second plate (15) switchable between a first end position in which it is moved towards the first plate (14) and a second end condition in which it is moved away from the first plate (14), said second slider (30) being configured to exert a compressive force on a portion of the electrochemical cell assembly (100) wherein the compressive force, measured per unit area, exerted by said second slider (30) is less than the compressive force, measured per unit area, exerted by said second plate (15).

8. Hipot test station (10) according to claim 2 and 6, wherein said first slider (25) comprises a contact surface (29) configured to contact a portion of an electrochemical cell assembly (100), wherein when said first slider (25) is in the first end position, said contact surface (29) of said first slider (25) is closer to the second plate (15) than the contact surface (16) of the first plate (14).

9. Hipot test station (10) according to claim 2 and 7, wherein said second slider (30) comprises a contact surface (34) configured to contact a portion of an electrochemical cell assembly (100), wherein when said second slider (30) is in the first end position, said contact surface (34) of said second slider (30) is closer to said first plate (14) than the contact surface (17) of the second plate (15).

10. Method for performing a Hipot test on an electrochemical cell assembly (100) comprising:
preparing a press (11) with a first plate (14) and a second plate (15) placed in an approaching relationship along a working direction contained in a horizontal plane;
moving an electrochemical cell assembly (100) along a vertical direction to insert the electrochemical cell assembly (100) between the first plate (14) and the second plate (15);
moving the first plate (14) towards the second plate (15) along the working direction and applying a compressive force to the electrochemical cell assembly (100);
wherein inserting the electrochemical cell assembly (100) between the first plate (14) and the second plate (15) comprises positioning the electrochemical cell assembly (100) between the first plate (14) and the second plate (15), subsequently bringing the first plate (14) towards the second plate (15) until a compressive force is applied on opposite side walls (103) of the electrochemical cell assembly (100) and subsequently releasing the electrochemical cell assembly (100);
supplying controlled voltages to the electrochemical cell assembly (100);
moving the electrochemical cell assembly (100) along a substantially vertical direction to remove the electrochemical cell assembly (100) from the press (11).

11. Method according to claim 10, wherein moving the electrochemical cell assembly (100) comprises retaining the electrochemical cell assembly (100) along a wall of the electrochemical cell assembly (100) other than side walls (103) of the electrochemical cell assembly (100) on which said press (11) is acting.

12. Method according to claim 10 or 11, wherein moving the electrochemical cell assembly (100) comprises retaining the electrochemical cell assembly (100) along a top (102) of the electrochemical cell assembly.

13. Method according to any one of claims 10 to 12, wherein moving the electrochemical cell assembly (100) comprises retaining the electrochemical cell assembly (100) along a lid (105) of the electrochemical cell assembly (100).

14. A method according to any one of claims 10 to 13, wherein removing the electrochemical cell assembly (100) from the press (11) comprises retaining the electrochemical cell assembly (100) while it is compressed between the first plate (14) and the second plate (15), subsequently moving the first plate (14) away from the second plate (15) and subsequently moving the electrochemical cell assembly (100) while it is being retained.
